## Europäisches Patentamt
## European Patent Office
## Office européen des brevets

(19)

(11) Numéro de publication: **0 068 938**
A1

(12)
# DEMANDE DE BREVET EUROPEEN

(21) Numéro de dépôt: **82401013.6**

(22) Date de dépôt: **04.06.82**

(51) Int. Cl.³: **H 03 K 4/02**

(30) Priorité: **10.06.81 FR 8111393**

(43) Date de publication de la demande: **05.01.83**
**Bulletin 83/1**

(84) Etats contractants désignés: **DE GB IT NL**

(71) Demandeur: **COMPAGNIE EUROPEENE DE TELETRANSMISSION C.E.T.T., 51, boulevard de la Republique, F-78400 Chatou (FR)**

(72) Inventeur: **Boos, Patrick, THOMSON-CSF SCPI 173, bld. Haussmann, F-75379 Paris Cedex 08 (FR)**

(74) Mandataire: **Turlèque, Clotilde et al, THOMSON-CSF SCPI 173, Bld Haussmann, F-75379 Paris Cedex 08 (FR)**

(54) Dispositif logique générateur de signal périodique.

(57)    Dispositif générateur de signal périodique, notamment de signal sinusoïdal, comportant un circuit logique séquentiel (1) possèdant huit sorties $Q_1$, chacune reliée à une résistance $R_i$, constituée d'un groupement de résistances de valeurs identiques R. Les résistances de valeur R sont d'une précision quelconque mais de faible dispersion. Par exemple elles sont fabriquées simultanément par un procédé classique d'intégration. La deuxième borne de chacune de ces résistances $R_i$ est reliée à la borne de sortie (3) du dispositif. Une borne d'entrée (15) reçoit un signal d'initialisation lors de la mise sous tension, et une borne d'entrée (2) reçoit un signal d'horloge, de fréquence seize fois supérieure à celle du signal de sortie.

    Application, notamment, aux modems pour transmission à déplacement de fréquence.

1

## DISPOSITIF LOGIQUE GENERATEUR DE SIGNAL PERIODIQUE

La présente invention concerne les générateurs de signal périodique, en particulier ceux dont la fréquence est fonction de celle d'un signal logique.

Ce type de signaux comprend notamment les signaux sinusoïdaux.

L'art antérieur connait deux méthodes pour réaliser cette fonction :

- générer des signaux logiques dit carrés, c'est-à-dire de rapport cyclique $\frac{1}{2}$ et les filtrer pour éliminer les harmoniques. Les filtres nécessaires pour obtenir un taux d'harmoniques très faible sont coûteux dans ce cas, car les harmoniques ont une forte amplitude;

- générer un signal, de forme proche de la courbe théorique souhaitée, en l'occurrence une sinusoïde, en le constituant d'une suite de paliers de tension dont chaque valeur est déterminée séparément par un ensemble de résistances. En général les valeurs de celles-ci ne se trouvent pas parmi les valeurs normalisées et néanmoins doivent être précises. Le signal est ensuite filtré pour atténuer les harmoniques. En pratique il est très gênant et coûteux de devoir utiliser des résistances de précision, surtout si elles diffèrent des valeurs normalisées courantes.

L'invention a pour objet de remédier à ces inconvénients par des moyens simples.

Selon l'invention un dispositif logique générateur d'un signal périodique, de période T, comportant une borne d'entrée pour recevoir un signal d'horloge, un circuit logique commandé par ce signal d'horloge pour fournir sur n sorties un mot binaire de n bits, variable, et où chaque sortie de rang i, $i = 1$ à n, alimente la première borne d'une résistance de valeur $R_i$, où la deuxième borne de chaque résistance de valeur $R_i$ est reliée à une borne commune qui constitue la borne de sortie du dispositif, et où le signal obtenu sur la borne de sortie variant par des sauts séparant des paliers d'amplitude constante, les valeurs de résistances $R_i$ sont calculées pour que les amplitudes de ces paliers suivent la courbe théorique du signal souhaité, est caractérisé en ce que les résistances de valeur $R_i$ sont constituées de groupements en série, en parallèle ou mixtes, de résistances ayant toutes une même valeur R; et en ce que chaque groupement constituant une résistance de valeur $R_i$ est composé de façon que la valeur de sa résistance équivalente soit sensiblement égale à la valeur $R_i$ calculée, tout en ne comportant qu'un nombre minimal de résistances de valeur R.

L'invention sera mieux comprise et d'autres caractéristiques apparaîtront dans la description ci-dessous et les figures s'y rapportant qui traitent d'un exemple de dispositif générant des signaux sinusoïdaux.

La figure 1 représente un exemple de signal $I_s$, intensité du courant obtenu en sortie du dispositif selon l'invention, par rapport au temps t.

La figure 2 représente le schéma synoptique d'un exemple de réalisation de ce dispositif.

Le dispositif selon l'invention fournit un signal dont le graphe approche la forme sinusoïdale souhaitée, en étant constitué d'un nombre fini de paliers, de durée identique, et dont l'amplitude varie d'un palier au suivant d'une valeur judicieusement choisie, d'une part pour que le milieu de chaque palier soit sur la courbe théorique, ou très proche, et d'autre part pour que le dispositif soit simple à fabriquer. Celui-ci génère un courant qui est constitué d'une somme de courants $I_i$. L'intensité de chaque courant $I_i$ est déterminée par une valeur de résistance $R_i$ unique. Chaque palier du signal généré est obtenu en additionnant ou en supprimant un des courants $I_i$. Il y a donc une relation directe entre chaque variation du signal et une des valeurs de résistance $R_i$.

Dans le but de faciliter la fabrication du dispositif chaque valeur de résistance $R_i$ est obtenu par un groupement en série, en parallèle, ou mixte d'un petit nombre de résistances identiques de valeur R. Le nombre des valeurs $R_i$ réalisables est donc limité par la complexité des groupements, c'est pourquoi il est nécessaire de choisir judicieusement les valeurs des variations entre paliers. La description ci-dessous détaille les deux étapes de la réalisation d'un exemple du dispositif selon l'invention :

- Approximation judicieuse de la courbe.

- Réalisation des groupements de résistances.

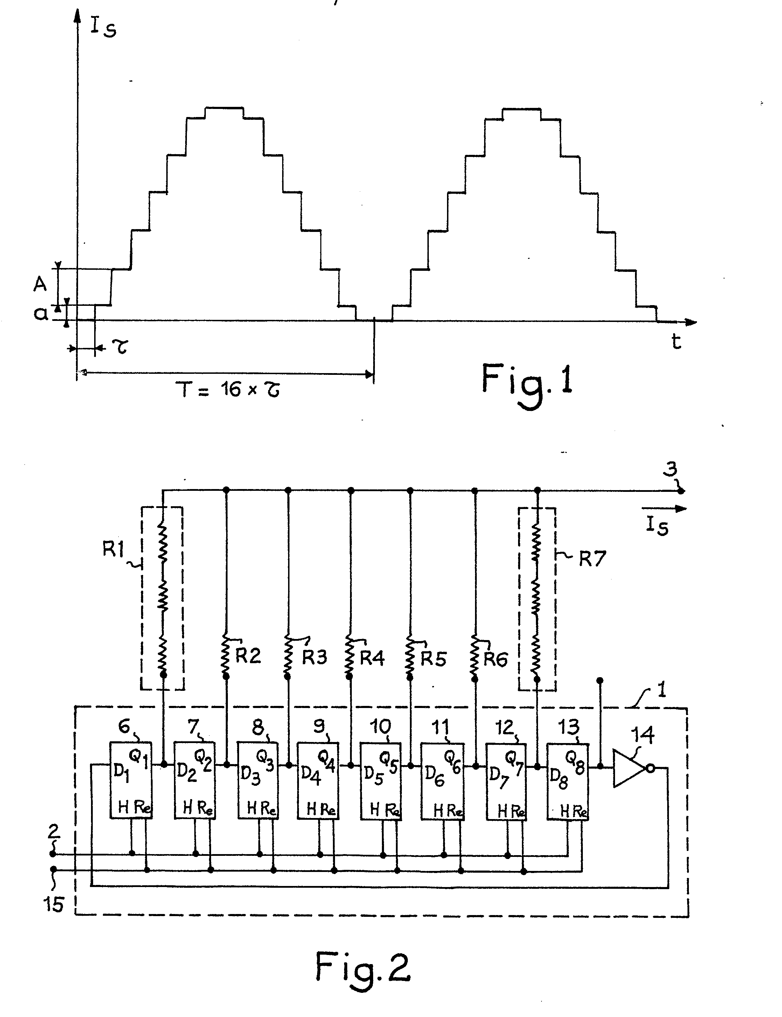

La figure 1 représente le signal $I_s$, intensité du courant, obtenu à la sortie du dispositif selon l'invention dans un exemple où la sinusoïde est constituée d'une suite de 16 paliers de durée τ, pendant chaque période de durée T, telle que :

$T = 16 \times \tau$

La sinusoïde peut être reconstituée en calculant l'amplitude de chaque palier de façon qu'elle soit égale à l'amplitude de la sinusoïde au milieu de la période $\tau$ considérée. Le signal serait le même, à une translation près, si c'était le début ou la fin des périodes $\tau$ qui étaient considérés pour ce calcul. D'autre part le choix final des valeurs des amplitudes des paliers tient compte de la facilité de réalisation des résistances $R_i$ et du taux d'harmoniques à ne pas dépasser.

Pendant la durée $\tau$ du premier palier le signal $I_s$ est nul, pendant le deuxième palier il a une amplitude a, pendant le troisième palier une amplitude a + A, pendant la quatrième palier une amplitude a + 2A, etc... à chaque palier l'amplitude augmente de A = 3a jusqu'au huitième palier. Pour le huitième palier l'amplitude n'augmente que de a. Pour le neuvième palier elle ne change pas. Pour le dixième palier l'amplitude diminue de a. Du onzième au quinzième palier l'amplitude diminue de A à chaque palier. Du quinzième au seizième palier l'amplitude diminue de a et s'annule, la période T est terminée.

Ce signal a une forme proche de la sinusoïde, le calcul prévoit que le taux d'harmonique deux est nul, et que le taux d'harmonique trois est de -34dB. Il est à la portée de l'homme de l'art d'utiliser un nombre de paliers différents, avec des amplitudes différentes pour synthétiser une sinusoïde. Dans tous les cas il faut au moins 8 paliers pour ne pas avoir trop d'harmoniques.

La figure 2 représente le schéma synoptique d'un exemple de réalisation du dispositif permettant d'obtenir le signal donné comme exemple sur la figure 1.

Le dispositif logique séquentiel 1 reçoit sur une borne d'entrée 2 un signal d'horloge de période $\tau$, et sur une borne d'entrée 15 un signal logique d'initialisation lors de la mise sous tension du dispositif 1. Ce dispositif comporte huit bascules de type D, 6 à 13, montées en cascade, c'est-à-dire que la sortie $Q_i$ de l'une est reliée à l'entrée $D_{i+1}$ de la suivante, pour i = 1 à 7. L'entrée $D_1$ de la première bascule est connectée à la sortie d'un inverseur logique 14, qui inverse le signal de la sortie $Q_8$ de la dernière bascule de la cascade. L'entrée $R_e$ de remise à zéro de chaque bascule est connectée à la borne d'entrée 15. L'entrée d'horloge, H, de chaque bascule est connectée à la borne d'entrée 2. A l'exception de la sortie $Q_8$, chaque sortie $Q_i$ d'une bascule est reliée par une borne de sortie du dispositif 1 à la première borne d'une résistance de valeur $R_i$ dont la deuxième borne est reliée à la borne 3 de sortie du dispositif selon l'invention.

Chaque résistance de valeur $R_i$ est constituée d'un groupement en série, en parallèle, ou mixte, d'un petit nombre de résistances identiques de valeur R. Dans l'exemple décrit les résistances de valeur $R_1$ et $R_7$ sont constituées de trois résistances élémentaires R en série :

$$R_1 = 3 \times R \; ; \; R_7 = 3 \times R.$$

Les autres résistances, de valeur $R_2$ à $R_6$, sont constituées chacune d'une résistance de valeur R.

Les résistances de valeur R n'ont pas besoin d'avoir une grande précision absolue, par contre leur valeur doit avoir une faible dispersion. Ce type de réseaux de résistances est facilement obtenu par les techniques classiques de fabrication de circuits intégrés, ce qui permet de réaliser le dispositif selon l'invention à un faible coût. L'intégration peut se limiter au réseau de résistances.

L'exemple de réalisation considéré constitue un générateur de courant sinusoïdal. Pour le faire fonctionner correctement la borne de sortie 3 du dispositif selon l'invention alimente une charge dont la valeur de résistance, R', est très faible par rapport à la valeur de résistance équivalente à $R_1,...R_7$ en parallèle. Par exemple cette charge peut être un dispositif convertisseur courant-tension à amplificateur opérationnel. Le courant $I_s$ dans la borne de sortie 3 est alors la somme des courants circulant dans $R_1,...,R_7$. Soit Vdd la tension d'alimentation du dispositif 1, la tension de chacune de ses sorties, en charge, est sensiblement égale à Vdd quand le niveau logique est 1. La borne de sortie 3 reçoit une somme de courants dont chaque intensité est $\dfrac{Vdd}{R_i}$ pour les sorties $Q_i$ qui sont au niveau 1.

Les sorties $Q_i$ qui sont au niveau 0 ne fournissent pas de courant car leur tension est sensiblement nulle; et n'en reçoivent pas puisque la borne de sortie 3 est chargée par une faible résistance, créant une chute de tension quasi-nulle.

Les sorties $Q_i$ des bascules prennent les états suivants :

| Impulsions d'horloge | $Q_1$ | $Q_2$ | $Q_3$ | $Q_4$ | $Q_5$ | $Q_6$ | $Q_7$ | $Q_8$ |
|---|---|---|---|---|---|---|---|---|
| 0 | 0 | 0 | 0 | 0 | 0 | 0 | 0 | 0 |
| 1 | 1 | 0 | 0 | 0 | 0 | 0 | 0 | 0 |
| 2 | 1 | 1 | 0 | 0 | 0 | 0 | 0 | 0 |
| 3 | 1 | 1 | 1 | 0 | 0 | 0 | 0 | 0 |
| 4 | 1 | 1 | 1 | 1 | 0 | 0 | 0 | 0 |
| 5 | 1 | 1 | 1 | 1 | 1 | 0 | 0 | 0 |
| 6 | 1 | 1 | 1 | 1 | 1 | 1 | 0 | 0 |
| 7 | 1 | 1 | 1 | 1 | 1 | 1 | 1 | 0 |
| 8 | 1 | 1 | 1 | 1 | 1 | 1 | 1 | 1 |
| 9 | 0 | 1 | 1 | 1 | 1 | 1 | 1 | 1 |
| 10 | 0 | 0 | 1 | 1 | 1 | 1 | 1 | 1 |
| 11 | 0 | 0 | 0 | 1 | 1 | 1 | 1 | 1 |
| 12 | 0 | 0 | 0 | 0 | 1 | 1 | 1 | 1 |
| 13 | 0 | 0 | 0 | 0 | 0 | 1 | 1 | 1 |
| 14 | 0 | 0 | 0 | 0 | 0 | 0 | 1 | 1 |
| 15 | 0 | 0 | 0 | 0 | 0 | 0 | 0 | 1 |
| 16 | 0 | 0 | 0 | 0 | 0 | 0 | 0 | 0 |

A la mise sous-tension un signal de remise à zéro, appliqué sur la borne d'entrée 15, remet toutes les sorties à zéro. Pendant la première demi-période $\frac{T}{2}$, à chaque impulsion d'horloge il y a une sortie qui passe au niveau logique 1 et qui y reste jusqu'à la fin de la demi-période. Après cette demi-période, à chaque impulsion d'horloge une sortie passe du niveau 1 au niveau 0 et y reste jusqu'à la fin de la période. Quand toutes les sorties sont revenues au niveau zéro une nouvelle période peut commencer. Ainsi $R_1$,..., $R_7$ sont successivement alimentées, puis $R_1$,...,$R_7$ sont successivement ramenées au potentiel nul, ce qui permet d'obtenir un courant $I_s$ tel que celui représenté sur la figure 1.

Le signal est une fonction paire si l'origine des temps est située à $t = \frac{T}{4}$ (figure 1). Une même résistance de valeur $R_i$ définit deux paliers, un à la montée et son symétrique à la descente. Ce dispositif est donc particulièrement économique par rapport aux dispositifs de l'art antérieur utilisant au moins une résistance (de précision) pour chaque palier.

Des mesures effectuées sur un tel signal révèlent un taux d'harmonique deux égal à -45 dB et d'harmonique trois égal à -33 dB. Le taux d'harmonique deux n'est pas absolument nul parce que les résistances n'ont pas une identité de valeur parfaite et parce que les temps de montée et de descente des signaux ne sont pas nuls comme on le suppose dans le calcul théorique.

Ces taux d'harmoniques, particulièrement faibles, permettent d'utiliser un filtre simple et bon marché pour obtenir une sinusoïde utilisable dans un modem, par exemple.

D'autre part il est à remarquer que la fréquence de cette sinusoïde peut facilement être modulée en modulant la fréquence d'horloge et que cette modulation, même si elle se fait par sauts, ne provoque pas de discontinuités dans la sinusoïde générée et par conséquent ne crée pas d'harmoniques parasites. C'est pourquoi les systèmes de transmission de données sur des lignes à basses fréquences utilisant la modulation à déplacement de fréquence sont une des applications possibles du dispositif selon l'invention générant des signaux sinusoïdaux.

Il est à la portée de l'homme de l'art de réaliser le dispositif selon l'invention en utilisant un dispositif logique 1 ayant un nombre de sorties différent de 8 et en utilisant d'autres groupements en série ou en parallèle pour constituer les résistances de valeur $R_1$, etc... à partir de résistances élémentaires identiques de valeur R. Augmenter le nombre de paliers permet de diminuer le taux d'harmoniques.

D'autre part il est possible d'utiliser un circuit logique dont les sorties réalisent, non pas une commande en tension, mais une commande en courant, c'est-à-dire se comportent comme des interrupteurs.

Le dispositif selon l'invention permet de générer d'autres types de signaux. Si, comme dans l'exemple décrit, le circuit logique 1 fournit un mot binaire de n bits dont la valeur après l'impulsion de rang k, modulo 2n, est :

$$2^k - 1 \text{ pour } k = 0 \text{ à } n$$
$$2^k - 2^{k-n} \text{ pour } k = n + 1 \text{ à } 2n$$

le signal généré a des paliers identiques à la montée et à la descente, le graphe de sa fonction temporelle possède un axe de symétrie, qui traduit le fait qu'elle est paire, pour une certaine origine des temps. Pour générer des signaux ne possédant pas d'axe de symétrie, c'est-à-dire dont la fonction n'est pas paire, il suffit d'utiliser une résistance de valeur $R_i$ différente pour chaque palier et alimentée une seule fois pendant la période T. Le nombre des groupements de résistances est alors égal au nombre de paliers. Il est à la portée de l'homme de l'art de réaliser un circuit logique 1 où chaque sortie passe au niveau logique 1, par exemple, une seule fois par période T.

## REVENDICATIONS

1. Dispositif logique générateur d'un signal périodique, de période T, comportant une borne d'entrée (2) pour recevoir un signal d'horloge, un circuit logique (1) commandé par ce signal d'horloge pour fournir sur n sorties un mot binaire de n bits, variable, et où chaque sortie de rang i, i = 1 à n, alimente la première borne d'une résistance de valeur $R_i$, où la deuxième borne de chaque résistance de valeur $R_i$ est reliée à une borne commune qui constitue la borne de sortie (3) du dispositif, et où le signal obtenu sur la borne de sortie (3) variant par des sauts séparant des paliers d'amplitude constante, les valeurs de résistances $R_i$ sont calculées pour que les amplitudes de ces paliers suivent la courbe théorique du signal souhaité, caractérisé en ce que les résistances de valeur $R_i$ sont constituées de groupements en série, en parallèle ou mixtes, de résistances ayant toutes une même valeur R; et en ce que chaque groupement constituant une résistance de valeur $R_i$ est composé de façon que la valeur de sa résistance équivalente soit sensiblement égale à la valeur $R_i$ calculée, tout en ne comportant qu'un nombre minimal de résistances de valeur R.

2. Dispositif selon la revendication 1 générateur d'un signal de période T et fonction paire du temps, caractérisé en ce que le circuit logique (1) fournit sur ses sorties un mot binaire de n bits dont la valeur après l'impulsion d'horloge de rang k modulo 2n est :

$2^k-1$ pour k = 0 à n

$2^n-2^{k-n}$ pour k = n + 1 à 2n.

3. Dispositif selon l'une quelconque des revendications 1 ou 2, générant un signal constitué par l'intensité circulant dans une charge résistive branchée entre la borne de sortie (3) et une borne au potentiel de référence, charge de valeur R' très inférieure à la valeur de la résistance équivalente à toutes les résistances de valeur $R_i$ en parallèle, caractérisé en ce que chaque sortie du circuit logique (1) est équivalente à un générateur de tension dont la force électromotrice varie en fonction de l'état logique et dont la résistance interne est négligeable devant la valeur R.

4. Dispositif selon l'une quelconque des revendications 1 à 3, générant un signal sinusoïdal et caractérisé en ce qu'il comporte un circuit logique (1) constitué de huit bascules de type D montées en cascade, la

sortie $Q_i$ de la i$^{\text{ème}}$ étant reliée à l'entrée $D_{i+1}$ de la i + 1$^{\text{ième}}$ pour i = 1 à 7, et la sortie $Q_8$ étant reliée à l'entrée $D_1$ par un inverseur logique; deux résistances, de valeur $R_1$ et $R_7$, constituées chacune de trois résistances de valeur R en série; cinq résistances de valeur $R_2$, $R_3$, $R_4$, $R_5$, $R_6$ constituées chacune d'une seule résistance de valeur R; une résistance de valeur $R_8$ infinie; une borne d'entrée (2) pour recevoir un signal d'horloge de période $\frac{T}{16}$ et une borne d'entrée (15) pour recevoir un signal d'initialisation, lors de la mise sous tensions, et le transmettre à des entrées de remise à zéro des bascules.

5. Dispositif selon l'une quelconque des revendications 1 à 4, caractérisé en ce que les résistances de valeur R sont réalisées simultanément par une des techniques d'intégration de circuits.

Fig.1

Fig.2

# 0068938

Office européen
des brevets

**RAPPORT DE RECHERCHE EUROPEENNE**

Numéro de la demande

EP   82 40 1013

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl. 3) |
|---|---|---|---|
| A | IEEE TRANSACTIONS ON INSTRUMENTATION AND MEASUREMENT, vol.IM-18, no.2, juin 1969, New York (US)<br>A.C. DAVIES: "Digital generation of low-frequency sine waves", pages 97-105 * pages 97 à 99 en entier *<br><br>----- | 1 | H 03 K   4/02 |

**DOMAINES TECHNIQUES RECHERCHES (Int. Cl. 3)**

H 03 K
G 06 G

Le présent rapport de recherche a été établi pour toutes les revendications

| Lieu de la recherche | Date d'achèvement de la recherche | Examinateur |
|---|---|---|
| LA HAYE | 17-09-1982 | GYSEN L.A.D. |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82